# EUROPÄISCHE PATENTSCHRIFT

(11) **EP 2 089 653 B1**
(45) Veröffentlichungstag und Bekanntmachung des Hinweises auf die Patenterteilung: **15.09.2010**
(21) Anmeldenummer: 07822078.7
(22) Anmeldetag: 31.10.2007
(51) Int. Cl.: F16P 3/08, G05B 9/03, H01H 47/00, D06F 37/42

(54) **VERFAHREN UND SCHALTUNGSANORDNUNG ZUR SICHEREN ANSTEUERUNG VON AKTOREN, SENSOREN UND/ODER VERBRAUCHERN IN EINEM DIESE ENTHALTENDEN ELEKTRISCHEN HAUSGERÄT**
METHOD AND CIRCUIT ARRANGEMENT FOR SECURE CONTROL OF ACTUATORS, SENSORS AND/OR USERS IN AN ELECTRICAL DOMESTIC APPLIANCE
PROCÉDÉ ET MONTAGE PERMETTANT UNE COMMANDE FIABLE D'ACTIONNEURS, DE CAPTEURS ET/OU DE RÉCEPTEURS DANS UN APPAREIL ÉLECTRO-MÉNAGER LES CONTENANT

(30) Priorität: 08.11.2006 DE 102006052739
(43) Veröffentlichungstag der Anmeldung: 19.08.2009
(73) Patentinhaber: BSH Bosch und Siemens Hausgeräte GmbH, 81739 München (DE)
(72) Erfinder: ALBAYRAK, Hasan Gökcer, 13469 Berlin (DE); SATTLER, Guido, 14612 Falkensee (DE)
(86) Internationale Anmeldenummer: PCT/EP2007/061730
(87) Internationale Veröffentlichungsnummer: WO 2008/055828

(56) Entgegenhaltungen:
- WO-A-2005/101440
- DE-A1- 10 156 771
- DE-A1- 19 504 249
- DE-A1- 19 504 249
- DE-A1-102005 034 911
- DE-A1-102005 034 911
- US-A- 5 175 413
- US-A- 5 175 413
- US-A- 6 166 505
- US-A1- 2005 027 375
- US-A1- 2005 027 375
- US-B1- 6 477 866
- US-B1- 6 477 866
- "NOT-AUS-SCHALTGERAETE, SCHUTZTUERWAECHTER" ANNOUNCEMENT PILZ NSG-D-1-051-07/00, Juli 2000 (2000-07), Seiten 1-4, XP000961973

## Beschreibung

Die Erfindung bezieht sich auf ein Verfahren zur sicheren Ansteuerung von Aktoren, Sensoren und/oder Verbrauchern eines elektrischen Hausgeräts in Form einer elektrisch arbeitenden Waschmaschine oder eines elektrisch arbeitenden Wäschetrockners mit wenigstens zwei entsprechend einer UND-Verknüpfung betriebenen Schaltgliedern zur Wirksamschaltung der genannten Aktoren, Sensoren bzw. Verbrauchern durch auf die Schaltglieder einwirkende Steuersignale und mit den weiteren Merkmalen des Oberbegriffs des Anspruches 1. Ferner betrifft die Erfindung eine Schaltungsanordnung eines elektrischen Hausgeräts in Form einer elektrisch arbeitenden Waschmaschine oder eines elektrisch arbeitenden Wäschetrockners zur Durchführung eines solchen Verfahrens mit den weiteren Merkmalen des Oberbegriffs des Anspruchs 6.

In elektrischen Geräten kann es notwendig sein, das Einnehmen bestimmter Betriebszustände in besonderer Weise zu überwachen. Ein solcher Betriebszustand ist z.B. das gesicherte Abschalten von Aktoren, Sensoren bzw. Verbrauchern nach dem Öffnen einer Tür eines solchen Gerätes, wie insbesondere einer elektrisch betriebenen Waschmaschine oder eines elektrisch arbeitenden Wäschetrockners, und das Beibehalten des Abschaltzustands nach dem erneuten Schließen der Tür und deren Verbleiben in diesem Zustand, bis durch eine Nutzeranforderung ein erneutes Einschalten der Aktoren, Sensoren bzw. Verbraucher per Ablaufsteuerung zugelassen werden kann. In elektronischen Steuerungseinrichtungen für elektrische Geräte, wie z.B. für Haushaltsgeräte, verhindern üblicherweise sogenannte geschützte elektronische Schaltungen - auch PECs (= Protected Electronic Circuit) genannt - derartige kritische Gerätezustände. Üblicherweise wird durch Software sichergestellt, dass solche kritischen Gerätezustände nicht auftreten können. Damit wird die Software selbst zum Bestandteil eines PECs. Das ordnungsgemäße Funktionieren der Software ist indessen in relativ aufwendigen Verfahren und Prüfungen zu qualifizieren. Diesen Aufwand zu vermeiden oder zumindest zu verringern, ist daher höchst wünschenswert.

Es ist bereits ein elektronischer Schalter mit zwei in Reihe liegenden Transistoren, z.B. zur Einschaltung eines Motors für die Laufstärkeeinstellung in einem Ton-Wiedergabegerät bekannt (DE 35 17 030 A1). Bei diesem bekannten elektronischen Schalter sind die Basen der beiden genannten Transistoren so entkoppelt, dass eine Schaltspannung auf beide Basen gelangt, bei einer unzulässig niederohmigen Überbrückung der Elektroden eines Transistors jedoch der andere Transistor nicht leitend wird. Dadurch wird verhindert, dass bei einem Kurzschluss der Elektroden eines Transistors der gesamte Schalter leitend wird. Dieser bekannte Schalter eignet sich jedoch nicht für einen Einsatz, wie er zuvor betrachtet worden ist.

Es ist ferner eine andere sogenannte redundante Sicherheitsschalteinrichtung zum Schalten einer Last bekannt (EP 1 131 684 B1 = DE 699 05 751 T2). Diese bekannte Sicherheitsschalteinrichtung enthält eine Schaltungsanordnung, bei der eine Last über zwei in Reihe geschaltete Schalter an einer Versorgungsspannung liegt. Dem einen, mit dem einen Pol einer Versorgungsspannungsquelle verbundenen Schalter ist ein Widerstand parallelgeschaltet. Mit diesem Widerstand ist ein Fehlerdetektor verbunden, welcher anhand der an dem betreffenden Widerstand abfallenden Spannung festzustellen gestattet, ob die beiden Schalter fehlerfrei arbeiten oder ob und gegebenenfalls welcher dieser beiden Schalter fehlerhaft arbeitet, also entweder kurzgeschlossen oder unterbrochen ist. Damit ist bei der betreffenden bekannten Sicherheitsschalteinrichtung die Steuervorrichtung der Schalter während der Deaktivierung ausfallsicher bzw. betriebssicher. Mit anderen Worten ausgedrückt heißt dies, dass es bei der bekannten Sicherheitsschalteinrichtung um ein sicheres Abschalten der Last im Falle des Auftretens von Fehlern in den Schaltern und der Steuereinrichtung geht. Dazu umfasst die erwähnte Steuereinrichtung eine Sequenzeinrichtung, welche bei Aktivierung zuerst ein erstes Steuersignal, das insbesondere ein Impulssignal ist, auf den ersten Steuerausgang schaltet, der den einen Schalter, welcher nicht dem erwähnten Widerstand parallelgeschaltet ist, steuert, und eine bestimmte Zeitspanne danach ein zweites Steuersignal, welches insbesondere ein Gleichstromsignal ist, dem zweiten Steuerausgang zuführt, das heißt damit den zweiten Schalter im Sinne einer Schließung steuert. Dadurch ist ermöglicht, die beiden Schalter auf ihre Funktionsfähigkeit zu überwachen.

Die vorstehend erwähnte Last wird übrigens von der Versorgungsspannung somit jeweils dann abgeschaltet, wenn wenigstens irgendeines der beiden Steuersignale entfällt; in diesem Fall ist nämlich die durch die beiden genannten Schalter festgelegte Schaltstrecke unterbrochen. Für eine Durchschaltung der betreffenden Schaltstrecke durch Steuersignale, deren eines ein Impulssignal ist und deren anderes ein Dauersignal ist, und für eine anschließende Unterbrechung der Schaltstrecke allein durch Abschalten des erwähnten Dauersignals eignet sich die betreffende bekannte Sicherheitsschalteinrichtung indessen nicht.

Es ist außerdem eine Sicherheitsschaltungsanordnung zur Ansteuerung eines Sicherheitsrelais einer elektronisch geregelten Bremsanlage eines Kraftfahrzeugs bekannt (DE 39 24 988). Diese bekannte Schaltungsanordnung weist mindestens zwei mit ihren Schaltstrecken in Reihe geschaltete Transistoren und eine Prüfschaltung auf, die beim Auftreten eines Fehlers oder einer Störung die Transistoren sperrt. Die Funktionsfähigkeit der Transistoren und der Prüfschaltung wird in regelmäßigen Zeitabständen, z.B. bei jedem Einschalten der Motorzündung des Kraftfahrzeugs, überprüft. Der Ausfall eines der Transistoren oder der Prüfschaltung führt zur Abschaltung des Sicherheitsrelais. Allerdings eignet sich die betreffende bekannte Sicherheitsschaltungsanordnung nicht für eine sichere Durchschaltung der erwähnten Schaltstrecke durch Steuersignale, deren eines ein Impulssignal ist und deren anderes ein Dauersignal ist, sowie für eine anschließende Unterbrechung der Schaltstrecke allein durch Abschalten des erwähnten Dauersignals, da bei der betreffenden bekannten Sicherheitsschaltungsanordnung beide erwähnten Signale gleichartige Signale sind.

Es sind schließlich auch schon ein Verfahren und eine Schaltungsanordnung zur gesicherten Ansteuerung von Aktoren, Sensoren bzw. Verbrauchern in einem diese enthaltenden elektrischen Gerät, insbesondere in einem elektrischen Hausgerät vorgeschlagen worden (DE 10 2005 034 911.0), welches eine Steuereinrichtung aufweist, von der lediglich bei ordnungsgemäßem Betrieb des betreffenden elektrischen Gerätes zusätzlich eine zumindest eine bestimmte Charakteristik aufweisende gesonderte Signal- bzw. Impulsfolge abgegeben wird, deren Auftreten überwacht wird. Dabei werden auf die Ermittlung lediglich einer solchen, die bestimmte Charakteristik aufweisenden gesonderten Signal- bzw. Impulsfolge auf der Ausgangsseite der betreffenden Steuereinrichtung hin die betreffenden Aktoren und/oder Sensoren und/oder Verbraucher für die Aufnahme bzw. Ausführung der ihnen von der Steuereinrichtung zugeführten Steuersignale freigegeben. Damit kann zwar eine hohe Sicherheit für ein elektrisches Hausgerät gewährleistet werden; allerdings lassen sich dieses Verfahren und diese Schaltungsanordnung nicht mit einem Dauersignal und einem Impulssignal, also einem einzelnen Impuls betreiben.

Ferner sind so genannte "Not-Aus-Schaltgeräte" bzw. "Schutztürwächter" für ein modulares Sicherheitssystem bekannt, welche im Datenblatt des PNOZplus - Mastergerät der Firma Pilz (NSG-D1-051-07/00, Juli 2000, Seite 1 bis 4) offenbart werden.

Eine Sicherheitsschalteinrichtung mit einer Sicherheitsschaltung umfassend ein Schaltelement mit mindestens einem aktiven und inaktiven Schaltzustand ist aus WO 2005/101440 A1 bekannt. Diese Sicherheitsschalteinrichtung weist eine Diagnosefunktionalität auf und ist dazu ausgebildet, dass im Falle eines Funktionsfehlers das Schaltelement in den inaktiven Schaltzustand gebracht wird.

Die Schalteinrichtung nach US 6,166,505 umfasst mehrere Schaltelemente, die voneinander unabhängig einen Schaltzustand überwachen können.

Darüber hinaus ist in DE 101 56 771 A1 ein elektrisches Haushaltsgerät mit einem Hauptschalter offenbart, der eine vorbestimmte Einschalt-Betätigungszeitdauer aufweis

Ein Wäschetrockner mit eine Relaisschaltung zur Austeuerung seiner Heizspulen ist aus DE 195 04 249 A1 bekannt.

Der Erfindung liegt daher die Aufgabe zugrunde, einen Weg zu zeigen, wie bei einem Verfahren und einer Schaltungsanordnung der eingangs genannten Art auf besonders einfache, aber dennoch wirksame Weise Aktoren und/oder Sensoren und/oder Verbraucher eines elektrischen Hausgeräts in Form einer elektrisch arbeitenden Waschmaschine oder eines elektrisch arbeitenden Wäschetrockners mittels Schaltglieder dadurch sicher angesteuert werden können, dass zu deren Wirksamschalten zwei unterschiedliche Steuersignale erforderlich sind und dass zu deren Unwirksamschalten und Unwirksamhalten lediglich der Wegfall eines bestimmten Steuersignals der beiden Steuersignale führt.

Gelöst wird die vorstehend aufgezeigte Aufgabe bei einem Verfahren der eingangs genannten Art erfindungsgemäß durch die Merkmale des Anspruchs 1.

Die Erfindung bringt den Vorteil mit sich, dass für die sichere Ansteuerung der Aktoren und/oder Sensoren und/oder elektrischen Verbrauchei eines Hausgeräts zwei Steuersignale erforderlich sind, die unabhängig voneinander auftreten. Lediglich durch die ordnungsgemäße Abgabe der beiden Steuersignale, nämlich des Dauersignals und des Impulssignals, lassen sich die vorgesehenen bistabilen Steuerglieder einschalten und dadurch mittels Schaltgliedern die Aktoren und/oder Sensoren und/oder Verbraucher wirksam und sicher schalten. Um die betreffenden Aktoren, Sensoren bzw. Verbraucher wieder wirksam und sicher abzuschalten und im Abschaltzustand zu belassen, genügt allein die Abschaltung des genannten Dauersignals. Die erneute alleinige Abgabe des Dauersignals bewirkt dann nämlich kein erneutes Einschalten der bistabilen Steuerglieder. Damit sind mit dem Verfahren gemäß der Erfindung die Bedingungen zu erfüllen, denen die eingangs erwähnten PECs genügen müssen.

Zweckmäßigerweise wird die Abgabe des Impulssignals überwacht, und lediglich bei dessen Abgabe mit einer unterhalb einer festgelegten Dauer liegenden Dauer und bei Vorhandensein des genannten Dauersignals werden die genannten Aktoren, Sensoren bzw. elektrischen Verbraucher wirksam geschaltet. Hierdurch ergibt sich der Vorteil, dass auf relativ einfache Weise eine fehlerhafte Abgabe des Impulssignals, insbesondere als Dauersignal erkannt und als Störfall ausgewertet werden kann.

Vorzugsweise wird das Dauersignal auf seine ordnungsgemäße Abgabe bzw. auf sein Vorhandensein überwacht. Dadurch ergibt sich der Vorteil, dass eine fehlerhafte Ansteuerung der jeweiligen bistabilen Steuerglieder durch das erwähnte Dauersignal leicht erkannt werden kann.

Vorzugsweise werden auch von den beiden bistabilen Steuergliedern abgegebene Ausgangssignale auf ihre ordnungsgemäße Abgabe überwacht. Dadurch sind in vorteilhafter Weise die betreffenden bistabilen Steuerglieder ebenfalls in die Funktionsüberwachung mit einbezogen.

Entsprechend einer weiteren zweckmäßigen Ausgestaltung des Verfahrens gemäß der Erfindung wird die Abgabe des Impulssignals, des Dauersignals und der Ausgangssignale der bistabilen Schaltglieder in einer Steuereinrichtung überwacht, durch die lediglich bei ordnungsgemäßem Auftreten des Impulssignals, des Dauersignals und der Ausgangssignale der bistabilen Steuerglieder die Aktoren, Sensoren und/oder Verbraucher wirksam gesteuert werden. Hierdurch ergibt sich der Vorteil einer besonders wirksamen Überwachung der genannten Signale. Die betreffenden Signale lassen sich nämlich mit ein und derselben Überwachungseinrichtung auf ihr ordnungsgemäßes Auftreten überwachen.

Gelöst wird die oben angegebene Aufgabe gemäß der vorliegenden Erfindung ferner durch eine Schaltungsanordnung eines Hausgeräts in Form einer elektrisch arbeitenden Waschmaschine oder eines elektrisch arbeitenden Wäschetrockners, die zur Durchführung des Verfahrens gemäß der Erfindung und zur sicheren Ansteuerung von elektrischen Aktoren, Sensoren und/oder Verbrauchern in Hausgeräten dient und die wenigstens zwei entsprechend einer UND-Verknüpfung betriebene Schaltglieder zum Wirksamschalten der genannten Aktoren, Sensoren und/oder Verbraucher durch auf die Schaltglieder einwirkende Steuersignale aufweist und die die weiteren Merkmale des Anspruchs 6 umfasst. Diese Schaltungsanordnung ist gemäß der vorliegenden Erfindung unter anderen dadurch gekennzeichnet, dass für die Steuersignalabgabe eine Dauersignal-Abgabeeinrichtung und eine Impulssignal-Abgabeeinrichtung vorgesehen sind, die an eine der Anzahl der Schaltglieder entsprechende Anzahl von bistabilen Steuergliedern ein Dauersignal bzw. ein Impulssignal abzugeben gestatten, und dass die bistabilen Steuerglieder durch die Abgabe des genannten Dauersignals und durch die Abgabe des genannten Impulssignals während der Dauer der Abgabe des betreffenden Dauersignals in einen eingeschalteten Zustand, in welchem die Schaltglieder wirksam schaltbar sind, und allein durch Abschalten des genannten Dauersignals in einem ausgeschalteten Zustand steuerbar, in welchem die Schaltglieder wirksam abgeschaltet sind, und in diesem ausgeschalteten Zustand auch bei erneuter Abgabe des betreffenden Dauersignals haltbar sind.

Hierdurch ergibt sich der Vorteil eines insgesamt relativ geringen Schaltungsaufwands für die wirksame Ansteuerung der erwähnten Schaltglieder und damit der Aktoren und/oder Sensoren und/oder Verbraucher. Darüber hinaus ist durch relativ geringen Schaltungsaufwand sichergestellt, dass die betreffenden Schaltglieder und damit die erwähnten Aktoren, Sensoren und/oder Verbraucher lediglich bei Abgabe des Dauersignals und des Impulssignals in der angegebenen festgelegten Reihenfolge wirksam geschaltet werden können und nach Abschalten des erwähnten Dauersignals in den ausgeschalteten Zustand gelangen und in diesem auch verbleiben, also durch erneute alleinige Abgabe des betreffenden Dauersignals nicht wieder wirksam geschaltet werden können. Damit erfüllt diese Schaltungsanordnung gemäß der Erfindung die Bedingungen, die an eine geschützte elektronische Schaltung (PEC) gestellt sind, wie sie eingangs erwähnt worden ist.

Die erfindungsgemäße UND-Verknüpfung zweier Schaltglieder wird insbesondere dargestellt durch eine Reihenschaltung dieser Schaltglieder. Diese Reihenschaltung muss lediglich die gewünschte Funktionalität im Sinne der erforderlichen UND-Verknüpfung bieten, nicht notwendigerweise aber eine räumliche Nähe der beiden Schaltglieder zueinander implizieren. Eine derartige Nähe kann hinsichtlich der konstruktiven Auslegung der entsprechenden Schaltungsanordnung allerdings von Vorteil sein.

Ferner sind die Aktoren und/oder Sensoren und/oder Verbraucher unter Einbeziehung der Schaltglieder mit einer Relaisschaltung verbunden, die von einer Steuereinrichtung ansteuerbar ist.

Für die Verbindung der Schaltglieder mit den Relaisschaltungen sind zwei unterschiedliche Schaltungsmöglichkeiten vorgesehen. Gemäß der einen Schaltungsmöglichkeit sind die Schaltglieder mit den Speisestromkreisen der den elektrischen Aktoren und/oder Sensoren und/oder Verbrauchern zugehörigen Relais gemeinsam verbunden. Gemäß der anderen Schaltungsmöglichkeit sind die Schaltglieder mit Kontakten der den elektrischen Aktoren, Sensoren und/oder Verbrauchern zugehörigen Relais gemeinsam verbunden und mit diesen Kontakten in Speisestromkreisen der betreffenden elektrischen Aktoren, Sensoren und/oder Verbraucher angeordnet. In beiden Fällen ergibt sich der Vorteil eines besonders geringen schaltungstechnischen Aufwands für die Ansteuerung der elektrischen Aktoren, Sensoren und/oder Verbraucher durch die genannten Schaltglieder unter Einbeziehung der Relaisschaltung.

Entsprechend einer zweckmäßigen Weiterbildung der vorstehend betrachteten Schaltungsanordnung gemäß der Erfindung ist eine Impulssignal-Überwachungseinrichtung vorgesehen, durch die eine solche Überwachung des Impulssignals vornehmbar ist, dass lediglich bei Abgabe eines Impulssignals mit einer unterhalb einer festgelegten Dauer liegenden Dauer und bei Vorhandensein des genannten Dauersignals die Schaltglieder wirksam schaltbar sind. Auf diese Weise lässt sich bei fehlerhafter Impulssignalabgabe auf besonders einfache Weise die Wirksamschaltung der erwähnten Schaltglieder unterbinden.

Zweckmäßigerweise ist auch eine Dauersignal-Überwachungseinrichtung vorgesehen, die das von einer Dauersignal-Abgabeeinrichtung abgegebene Dauersignal auf seine ordnungsgemäße Abgabe überwacht. Durch diese Überwachung der Dauersignalabgabewird die Sicherheit des Wirksamschaltens der erwähnten Schaltglieder in vorteilhafter Weise noch weiter gesteigert.

Vorzugsweise sind die bistabilen Steuerglieder ausgangsseitig mit einer Überwachungseinrichtung verbunden, welche die Abgabe der von den betreffenden Steuergliedern jeweils abzugebenden Ausgangssignale überwacht. Durch diese Maßnahme sind die bistabilen Steuerglieder in vorteilhafter Weise in die Signalüberwachung mit einbezogen, so dass die Wirksamsteuerung der erwähnten Schaltglieder nur dann erfolgen kann, wenn auch die bistabilen Steuerglieder ordnungsgemäße Ausgangssignale abgeben.

Vorzugsweise sind die vorstehend genannten Überwachungseinrichtungen in einer gemeinsamen Steuereinrichtung enthalten, die vorzugsweise einen Mikrocomputer bzw. Mikrocontroller mit zugehöriger Software enthält bzw. durch diesen gebildet ist. Dies bringt den Vorteil eines besonders geringen schaltungstechnischen Aufwands für die Überwachungseinrichtungen mit sich.

Gemäß einer weiteren zweckmäßigen Ausgestaltung der Erfindung ist die Dauersignal-Abgabeeinrichtung durch einen Türschalterkontakt des erwähnten elektrischen Gerätes gebildet, und die Impulssignal-Abgabeeinrichtung ist durch einen Taster gebildet, der unabhängig von dem Türschalterkontakt betätigbar ist. Durch die unabhängige Betätigung von Türschalterkontakt und Taster wird eine besonders hohe Sicherheit hinsichtlich der Wirksamschaltung der genannten Schaltglieder sichergestellt.

Zweckmäßigerweise sind die elektrischen Aktoren und/oder Sensoren und/oder Verbraucher unter Einbeziehung der genannten Schaltglieder mit einer Relaisschaltung verbunden, die von einer Steuereinrichtung ansteuerbar ist, bei der es sich vorzugsweise um die zuvor genannte Steuereinrichtung handelt. Diese Maßnahme bringt den Vorteil einer einfachen galvanischen Trennung der elektrischen Aktoren und/oder Sensoren und/oder Verbraucher von den Schalteinrichtungen und der Steuereinrichtung mit sich. Eine solche galvanische Trennung ist aus Sicherheitsgründen häufig erwünscht bzw. erforderlich, weil zwischen den die üblicherweise mit relativ hoher Netzwechselspannung von z.B. 230V betriebenen Aktoren, Sensoren bzw. Verbraucher keine elektrisch leitende Verbindung mit ihren Ansteuerschaltungen haben dürfen, die mit relativ niedriger Spannung von z.B. +5V betrieben werden.

Vorzugsweise ist jedem elektrischen Aktor, Sensor und/oder Verbraucher ein gesondertes Relais zugehörig. Dadurch ergibt sich der Vorteil einer besonders einfachen Ansteuerung der jeweiligen elektrischen Aktoren, Sensoren und/oder Verbraucher.

Die bistabilen Steuerglieder sind vorzugsweise jeweils durch ein bistabiles Schaltungsglied, wie ein bistabiles Kippglied oder bistabiles elektronisches Bauelement gebildet. Dies bringt den Vorteil eines besonders geringen schaltungstechnischen Aufwands hinsichtlich der Realisierung der bistabilen Steuerglieder mit sich.

Vorzugsweise sind die bistabilen Steuerglieder jeweils aus Halbleiterelementen aufgebaut. Auch die Schaltglieder sind vorzugsweise durch Halbleiterelemente gebildet. Dadurch ergibt sich der Vorteil besonders einfach aufzubauender bistabiler Steuerglieder und Schaltglieder.

Anhand von Ausführungsformen wird die Erfindung nachstehend unter Bezugnahme auf Zeichnungen näher erläutert.

In den Zeichnungen zeigen
- Fig. 1: schematisch in einem Schaltungsdiagramm einen grundsätzlichen Aufbau einer Schaltungsanordnung gemäß einer ersten Ausführungsform der Er- findung,
- Fig. 2: schematisch in einem Schaltungsdiagramm eine Abwandlung der in Fig. 1 dargestellten Schaltungsanordnung gemäß einer zweiten Ausführungs- form der Erfindung,
- Fig. 3: schematisch in einem Schaltungsdiagramm einen möglichen Aufbau ei- nes bistabilen Steuergliedes, wie es in den Schaltungsanordnungen ge- mäß Fig. 1 und 2 verwendet ist, und
- Fig. 4: schematisch in einem Schaltungsdiagramm einen anderen möglichen Aufbau eines bistabilen Steuergliedes, wie es in den Schaltungsanord- nungen gemäß Fig. 1 und 2 vorgesehen ist.

Bevor auf die Zeichnungen näher eingegangen wird, sei angemerkt, dass einander entsprechende Elemente in sämtlichen Zeichnungen mit gleichen Bezugszeichen bezeichnet sind.

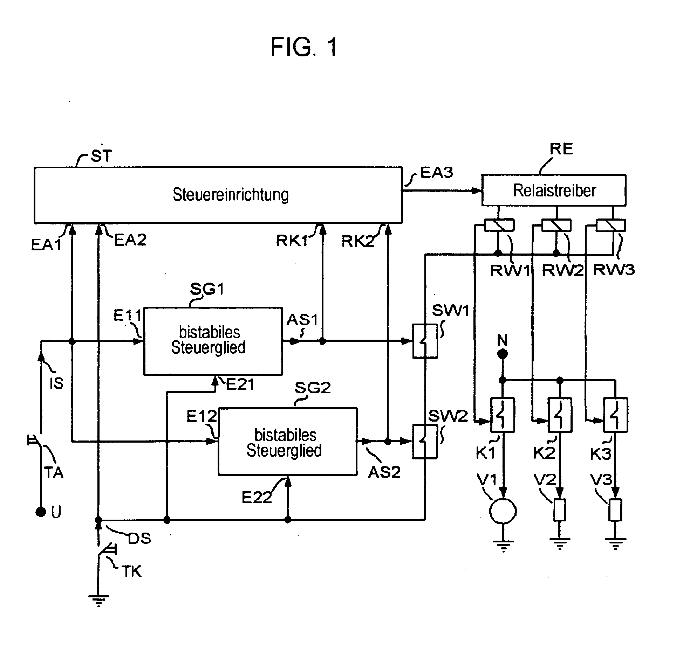

Die in Fig. 1 dargestellte Schaltungsanordnung dient zur sicheren Ansteuerung von elektrischen Aktoren und/oder Sensoren und/oder Verbrauchern, die in Fig. 1 mit V1, V2 und V3 bezeichnet sind. Bei den Aktoren kann es sich beispielsweise um Schaltschütze, Wenderelais, etc. in elektrischen Hausgeräten handeln. Bei den erwähnten elektrischen Sensoren kann es sich beispielsweise um Temperatursensoren, Füllstands- bzw. Wasserstands-Sensoren, etc. handeln, wie sie in elektrisch betriebenen Hausgeräten vorgesehen sind. Bei den erwähnten elektrischen Verbrauchern kann es sich beispielsweise um Elektromotoren, Heizwiderstände, etc. handeln, wie sie ebenfalls in elektrisch betriebenen Hausgeräten enthalten sind.

Die vorstehend erwähnten elektrischen Aktoren und/oder Sensoren und/oder Verbraucher V1, V2, V3 werden, wie nachstehend noch näher ersichtlich werden wird, durch wenigstens zwei entsprechend einer UND-Verknüpfung betriebene Schaltglieder SW1 und SW2 mittels auf die Schaltglieder SW1 und SW2 einwirkender Steuersignale aktiviert. Wie aus Fig. 1 ersichtlich ist, sind die beiden Schaltglieder SW1 und SW2, die beispielsweise durch Halbleiterschalter gebildet sein können, mit ihren Schaltstrecken in Reihe geschaltet. Dabei ist das Schaltglied SW1 der betreffenden Reihenschaltung mit seinem einen Schaltstreckenanschluss mit den einen Enden von Relaiswicklungen RW1, RW2 und RW3 von elektromagnetischen Relais verbunden, die individuell für den jeweiligen Aktor bzw. Sensor bzw. Verbraucher V1, V2, V3 vorgesehen sind. Jeder der Relaiswicklungen RW1, RW2 und RW3 ist ein Arbeitskontakt K1, K2 bzw. K3 zugehörig, über den das jeweils eine Ende des jeweiligen elektrischen Aktors, Sensors bzw. Verbrauchers V1, V2, V3 an einem gemeinsamen Schaltungspunkt N angeschlossen ist, der beispielsweise eine 50-Hz-Netzwechselspannung von 230V führen kann. Die anderen Enden der elektrischen Aktoren, Sensoren und/oder Verbraucher V1, V2, V3 liegen im vorliegenden Fall beispielsweise auf Masse- bzw. Erdpotential.

Die zuvor erwähnten Relaiswicklungen RW1, RW2, RW3 sind mit ihren anderen, noch nicht erwähnten Enden mit der Ausgangsseite eines in seinem Aufbau hier nicht näher dargestellten Relaistreibers RE verbunden. Dieser Relaistreiber RE kann beispielsweise durch einzelne Steuertransistoren gebildet sein, deren Schaltstrecken individuell mit den erwähnten Relaiswicklungen RW1, RW2 bzw. RW3 verbunden sind und deren Steuerelektroden gemeinsam mit einem in Fig. 1 angedeuteten Eingang des Relaistreibers RE verbunden sind. Der betreffende Eingang des Relaistreibers RE ist mit einem Ausgang EA3 einer Steuereinrichtung ST verbunden, auf die weiter unten näher eingegangen wird. Die zuvor erwähnten Steuertransistoren können mit ihren Schaltstreckenelektroden, die nicht mit den Relaiswicklungen RW1, RW2 bzw. RWS3 verbunden sind, beispielsweise an einem eine Gleichspannung von +5V führenden Schaltungspunkt angeschlossen sein.

Bei der in Fig. 1 dargestellten Schaltungsanordnung ist das Schaltglied SW2 der aus den beiden Schaltgliedern SW1 und SW2 bestehenden Reihenschaltung mit seinem einen Schaltstreckenanschluss mit einem Anschluss eines eine Dauersignal-Abgabeeinrichtung darstellenden Kontaktes TK verbunden, der mit seinem anderen Anschluss an Erde bzw. Masse liegt. Dieser Kontakt TK ist ein Türkontakt einer elektrisch arbeitenden Waschmaschine oder eines elektrisch arbeitenden Wäschetrockners, der bei geschlossener Tür geschlossen ist und in diesem Fall ein Dauersignal (Masse- bzw. Erdpotential) abgibt. Dieses Dauersignal DS liegt dann in Fig. 1 am unteren Ende des Schaltgliedes SW2 an; es kann erst dann die zuvor betrachteten Relaiswicklungen RW1, RW2 und RW3 erregen, wenn die beiden entsprechend einer UND-Verknüpfung miteinander verbundenen Schaltglieder SW1 und SW2 betätigt, also geschlossen sind. Dies ist jedoch zu diesem Zeitpunkt noch nicht der Fall.

Die Schaltglieder SW1 und SW2 sind mit ihren Betätigungseingängen an Ausgängen AS1 bzw. AS2 von zwei bistabilen Steuergliedern SG1 bzw. SG2 angeschlossen. Diese bistabilen Steuerglieder SG1 und SG2 sind generell in einer der Anzahl der Schaltglieder SW1, SW2 entsprechenden Anzahl vorgesehen. Diese Anzahl beträgt, wie eingangs erwähnt, zumindest zwei, und sie ist hier auch zwei.

Die in Fig. 1 dargestellten bistabilen Steuerglieder SG1 und SG2 weisen eingangsseitig jeweils zwei Steuereingänge auf. Das bistabile Steuerglied SG1 weist die beiden Steuereingänge E11 und E21 auf, und das bistabile Steuerglied SG2 weist die beiden Steuereingänge E12 und E22 auf. Die beiden Steuereingänge E21 und E22 der beiden bistabilen Steuerglieder SG1 und SG2 sind mit dem zuvor bereits erwähnten, eine Dauersignal-Abgabeeinrichtung bildenden Türkontakt TK des elektrischen Geräts verbunden, in welchem die gesamte Schaltungsanordnung eingesetzt ist. Die anderen beiden Steuereingänge E11 und E12 der beiden bistabilen Steuerglieder SG1 und SG2 sind mit einer Impulssignal-Abgabeeinrichtung TA verbunden, die gemäß Fig. 1 durch einen Taster TA gebildet ist, über den die betreffenden Steuereingänge E11 und E12 der beiden bistabilen Steuerglieder SG1 und SG2 mit einem Schaltungspunkt U verbunden sind, der eine Spannung von beispielsweise +2,7V führen kann. Der betreffende Taster TA ist dabei unabhängig von dem zuvor erwähnten Türkontakt TK betätigbar und natürlich auch getrennt von dem Türkontakt angeordnet. Durch Betätigen des Tasters TA wird ein Impulssignal IS in Form eines einzigen Spannungsimpulses von beispielsweise +2,7V abgegeben. Bei diesem Impulssignal handelt es sich also um einen Einzelimpuls, der bei ordnungsgemäßem Arbeiten des Tasters TA eine bestimmte Dauer aufweist, die unterhalb einer festgelegten Dauer liegt.

Der das erwähnte Impulssignal IS auf seine Betätigung hin abgebende Taster TA und der das erwähnte Dauersignal DS in seinem geschlossenen Zustand abgebende Türkontakt TK sind mit Eingangsanschlüssen EA1 bzw. EA2 der bereits erwähnten Steuereinrichtung ST verbunden, bei der es sich beispielsweise um einen Mikrocontroller mit eigener Software handeln kann. In dieser Steuereinrichtung ST werden das Impulssignal IS und das Dauersignal DS auf ihr ordnungsgemäßes Auftreten überwacht. Bezüglich des Impulssignals IS wird überwacht, ob dieses mit einer unterhalb einer festgelegten Dauer liegenden Dauer auftritt, und bezüglich des Dauersignals DS wird überwacht, ob dieses überhaupt auftritt. Durch die Überwachung des Impulssignals IS kann somit festgestellt werden, ob der Taster TA ordnungsgemäß arbeitet oder ob er infolge eines Fehlers überhaupt kein Impulssignal IS oder auch ein Dauersignal liefert, beispielsweise infolge eines sogenannten Hängenbleibens.

Die zuvor betrachtete Steuereinrichtung ST weist noch zwei weitere Eingangsanschlüsse auf, die mit RK1 und RK2 bezeichnet sind. Von diesen Eingangsanschlüssen ist der Eingangsanschluss RK1 mit einem Ausgangsanschluss AS1 des bistabilen Steuergliedes SG1 verbunden, der mit dem Betätigungseingang des oben erwähnten Schaltgliedes SW1 verbunden ist. Der andere Eingangsanschluss RK2 der Steuereinrichtung ST ist mit einem Ausgangsanschluss AS2 des bistabilen Steuergliedes SG2 verbunden, der mit dem Betätigungseingang des Schaltgliedes SW2 verbunden ist. Die Verbindungen zwischen dem Ausgangsanschluss AS1 des bistabilen Steuergliedes SG1 und des Ausgangsanschlusses AS2 des bistabilen Steuergliedes SG2 mit den zuvor erwähnten Eingangsanschlüssen RK1 bzw. RK2 der Steuereinrichtung ST stellen sogenannte Rückkanalverbindungen dar, über die in der Steuereinrichtung ST das Auftreten von Ausgangssignalen an den erwähnten Ausgangsanschlüssen AS1 und AS2 der beiden bistabilen Steuerglieder SG1 bzw. SG2 überwacht wird. Diese Überwachung erfolgt wie die Überwachung der an den Eingangsanschlüssen EA1 und EA2 der Steuereinrichtung ST auftretenden Signale durch Teile der Steuereinrichtung ST bildende Überwachungseinrichtungen. Diese Überwachungseinrichtungen können jedoch in der insbesondere durch einen Mikrocontroller mit eigener Software gebildeten Steuereinrichtung ST softwaremäßig realisiert sein.

Nachdem zuvor der Aufbau der in Fig. 1 dargestellten Schaltungsanordnung in dem für ein Verständnis der vorliegenden Ausführuangen ausreichendem Umfang erläutert worden ist, sei nunmehr die Arbeitsweise dieser Schaltungsanordnung näher betrachtet. Zunächst sei davon ausgegangen, dass sowohl der Türkontakt TK als auch der Taster TA geöffnet sind. In diesem Fall befindet sich die gesamte Schaltungsanordnung im Ruhe- bzw. Ausgangszustand, in welchem die bistabilen Steuerglieder SG1, SG2 sich im ausgeschalteten bzw. Rücksetzzustand befinden und in welchem die Schaltglieder SW1 und SW2 geöffnet sind und in welchem die elektrischen Aktoren und/oder Sensoren und/oder Verbraucher V1, V2, V3 nicht gespeist werden.

Wenn nunmehr der Taster TA betätigt wird, werden zwar die bistabilen Steuerglieder SG1 und SG2 und die Steuereinrichtung ST mit einem Impulssignal IS beaufschlagt, was allerdings keinerlei weitere Auswirkungen hat. Die dargestellte Schaltungsanordnung verbleibt in ihrem zuvor erwähnten Ruhe- bzw. Ausgangszustand. Auch wenn allein der Türkontakt TK zunächst geschlossen wird und geschlossen bleibt, bleibt der Ruhe- bzw. Ausgangszustand der in Fig. 1 dargestellten Schaltungsanordnung unverändert aufrechterhalten. Wenn allerdings zusätzlich bei geschlossenem Türkontakt TK der Taster TA betätigt wird - der somit als Starttaster wirkt - und damit ein Impulssignal IS abgegeben wird, gelangen die beiden bistabilen Steuerglieder SG1 und SG2 in ihren jeweiligen eingeschalteten bzw. Setzzustand. Eine erneute ein- oder mehrmalige zusätzliche Betätigung des Tasters TA hat übrigens auf den so erreichten Zustand der bistabilen Steuerglieder SG1 und SG2 keinerlei Auswirkung mehr.

In dem nunmehr erreichten Setzzustand geben die beiden bistabilen Steuerglieder SG1 und SG2 von ihren Ausgangsanschlüssen AS1 bzw. AS2 jeweils ein solches Ausgangssignal, wie beispielsweise ein einem binären Signal "1" entsprechendes Ausgangssignal von z.B. +2,7V ab, dass das mit ihrem jeweiligen Ausgangsanschluss AS1 bzw. AS2 mit seinem Steuereingang verbundene Schaltglied SW1 bzw. SW2 geschlossen wird. Dadurch erhalten nunmehr die mit der Reihenschaltung der Schaltglieder SW1 und SW2 verbundenen Enden der Relaiswicklungen RW1, RW2 und RW3 der Relaisschaltung Masse- bzw. Erdpotential von dem geschlossenen Türkontakt TK und gelangen in ihren Erregungszustand, sofern dem Relaistreiber RE eingangsseitig vom Ausgangsanschluss EA3 der Steuereinrichtung ST ein den ordnungsgemäßen Zustand der überwachten Signale anzeigendes Steuersignal (beispielsweise ein Binärsignal "1 ") zugeführt wird. Infolge der Erregung der Relaiswicklungen RW1, RW2 und RW3 werden die diesen zugehörigen Relaiskontakte K1, K2 bzw. K3 geschlossen, und damit wird die Netzspannung von dem Schaltungspunkt N an die elektrischen Aktoren und/oder Sensoren und/oder Verbraucher V1, V2 und V3 angelegt. Die betreffenden Aktoren, Sensoren bzw. Verbraucher V1, V2, V3 werden somit aktiviert.

Wird nun der Türkontakt TK wieder geöffnet, so hört die Abgabe des Dauersignals DS, also des Erd- bzw. Massepotentials über diesen Türkontakt TK auf. Dies hat nicht nur zur Folge, dass die Relaiswicklungen RW1, RW2 und RW3 der Relaisschaltung aberregt werden, sondern vor allem auch, dass die bistabilen Steuerglieder SG1, SG2 wieder in ihren ausgeschalteten bzw. Rücksetzzustand gelangen, in welchem die Schaltstrecken der Schaltglieder SW1 und SW2 wieder geöffnet sind. Die elektrischen Aktoren und/oder Sensoren und/oder Verbraucher V1, V2, V3 sind infolge der nunmehr geöffneten Relaiskontakte K1, K2 und K3 wieder von der Netzspannung am Schaltungspunkt N abgetrennt und damit deaktiviert.

Eine erneute Betätigung - ob absichtlich oder unabsichtlich - des Türkontakts TK soll keine erneute Aktivierung der gerade deaktivierten elektrischen Aktoren, Sensoren bzw. Verbraucher V1, V2 und V3 zur Folge haben, und sie hat auch eine solche erneute Aktivierung nicht zur Folge. Die alleinige Lieferung des Dauersignals DS durch den geschlossenen Türkontakt TK bringt nämlich die bistabilen Steuerglieder SG1 und SG2 nicht wieder in deren eingeschalteten bzw. Setzzustand zurück. Hierfür bedarf es vielmehr zusätzlich der Abgabe eines Impulssignals IS der festgelegten Dauer durch den erneut zu betätigenden Taster TA. Solange dieser Taster TA allerdings nicht betätigt wird, bleiben die bistabilen Steuerglieder SG1 und SG2 in ihren ausgeschalteten bzw. Rücksetzzuständen, und damit können die elektrischen Aktoren, Sensoren bzw. Verbraucher V1, V2, V3 nicht aktiviert werden.

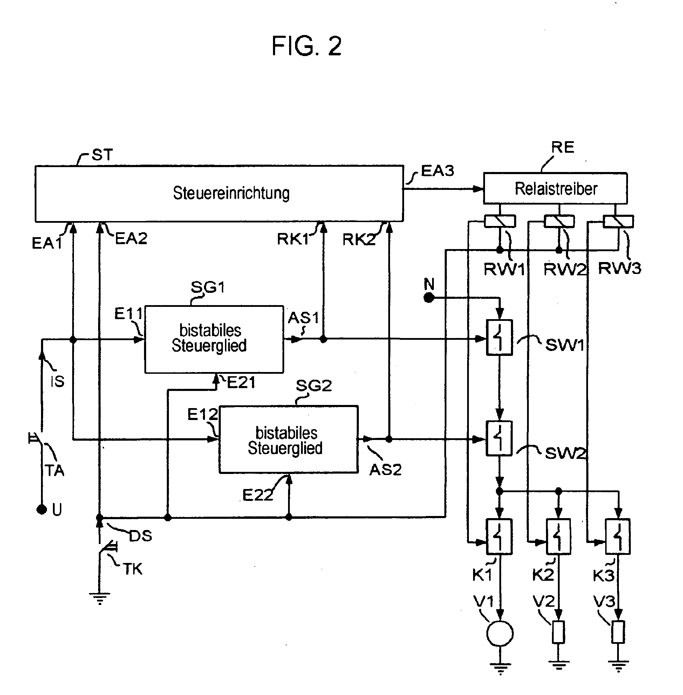

Während bei der in Fig. 1 dargestellten Schaltungsanordnung die Schaltglieder SW1, SW2 mit den Speisestromkreisen der den elektrischen Aktoren und/oder Sensoren und/oder Verbrauchern V1, V2, V3 zugehörigen Relais, genauer gesagt mit deren Relaiswicklungen RW1, RW2 und RW3 gemeinsam verbunden sind, zeigt Fig. 2 eine Modifikation der Verbindung der Schaltglieder SW1, SW2 mit den betreffenden Relais. Gemäß Fig. 2 sind nämlich die Schaltglieder SW1, SW2 mit den Relaiskontakten K1, K2, K3 der den elektrischen Aktoren, Sensoren bzw. Verbrauchern V1, V2, V3 zugehörigen Relais bzw. Relaiswicklungen RW1, RW2, RW3 gemeinsam verbunden und mit diesen Kontakten in Stromkreisen der betreffenden Aktoren, Sensoren bzw. Verbraucher V1, V2, V3 angeordnet. Bezogen auf die in Fig. 1 dargestellte Schaltungsanordnung heißt dies, dass diejenigen Enden der Relaiswicklungen RW1, RW2, RW3, die nicht mit dem Relaistreiber RE verbunden sind, direkt mit dem Türkontakt TK verbunden sind und dass die Reihenschaltung aus den beiden Schalteinrichtungen SW1 und SW2 in die Verbindungsleitung zwischen dem gemeinsamen Verbindungspunkt der Relaiskontakte K1, K2, K3 und dem Netzspannung führenden Schaltungspunkt N eingefügt ist. Der übrige Aufbau der in Fig. 2 dargestellten Schaltungsanordnung entspricht vollständig dem Aufbau der in Fig. 1 dargestellten Schaltungsanordnung, weshalb dieser Schaltungsaufbau hier nicht nochmals erläutert wird. Auch die Arbeitsweise der in Fig. 2 dargestellten Schaltungsanordnung bezüglich der Überführung der bistabilen Steuerglieder SG1 und SG2 aus ihren ausgeschalteten bzw. Rücksetzzuständen in ihre eingeschalteten bzw. Setzzustände und bezüglich der Wirksam-/Unwirksamsteuerung der elektrischen Aktoren, Sensoren bzw. Verbraucher V1, V2, V3 entspricht vollständig der zuvor erläuterten Arbeitsweise der in Fig. 1 dargestellten Schaltungsanordnung. Demgemäß ist eine gesonderte Erläuterung der Arbeitsweise der in Fig. 2 dargestellten Schaltungsanordnung hier entbehrlich.

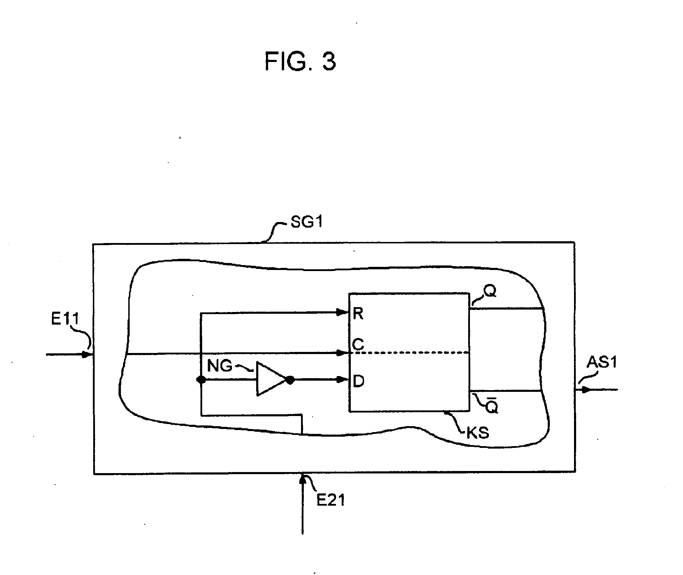

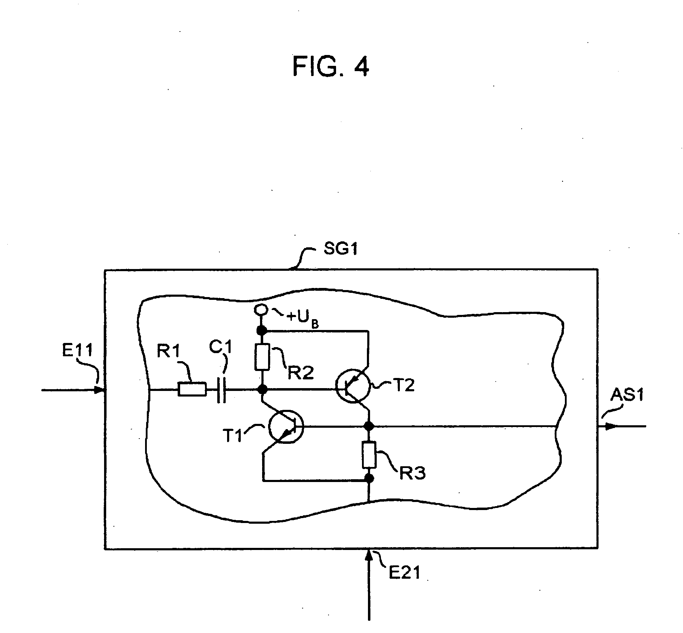

Im Folgenden werden zwei mögliche Realisierungsformen der in den Schaltungsanordnungen gemäß Fig. 1 und 2 vorgesehenen bistabilen Steuerglieder SG1 und SG2 erläutert. Da diese bistabilen Steuerglieder SG1 und SG2 in ihrem Aufbau identisch aufgebaut sein können und normalerweise auch identisch aufgebaut sind, wird anhand der Fig. 3 und 4 lediglich jeweils ein möglicher Aufbau des bistabilen Steuergliedes SG1 näher betrachtet.

Gemäß Fig. 3 enthält das bistabile Steuerglied SG1 ein bistabiles Kippglied KS, welches vorzugsweise ein bistabiles Kippglied vom D-Typ ist, wie es beispielsweise durch das bistabile Kippglied mit der Bezeichnung 74LVC1G74 gegeben ist. Dieses bistabile Kippglied GS weist einen Eingangs- bzw. Datenanschluss D auf, der über einen Negator bzw. ein Nicht-Glied NG mit dem Eingangsanschluss E21 des bistabilen Kippgliedes SG1 verbunden ist und dem somit das Dauersignal DS gemäß Fig. 1 und 2 zugeführt wird. Ferner weist das betreffende bistabile Kippglied KS einen Rücksetzeingang R auf, der im vorliegenden Fall mit dem Eingangsanschluss E21 des bistabilen Steuergliedes SG1 verbunden ist. Außerdem weist das bistabile Kippglied KS einen Takteingang C auf, der mit dem Eingangsanschluss E11 des bistabilen Steuergliedes SG1 verbunden ist, also mit dem Steuereingang, dem das Impulssignal IS gemäß Fig. 1 und 2 zugeführt wird. Ausgangsseitig weist das bistabile Kippglied KS zwei Ausgänge *Q* und *Q* auf, von denen im vorliegenden Fall der Ausgang *Q̅* mit dem Ausgangsanschluss AS1 des bistabilen Steuergliedes SG1 verbunden ist.

Im Folgenden wird die Arbeitsweise des in Fig. 3 dargestellten bistabilen Steuergliedes SG1 kurz betrachtet. Die alleinige Zuführung eines Signals - im vorliegenden Fall des im Zusammenhang mit Fig. 1 genannten Impulssignals IS - am Eingangsanschluss E11 und damit am Takteingang C des bistabilen Kippgliedes KS kann lediglich bewirken, dass dieses bistabile Kippglied entsprechend dem am Eingangsanschluss E21 des bistabilen Steuergliedes SG anliegenden Eingangssignals eingestellt wird. Wird diesem Eingangsanschluss E21 kein einem Binärsignal "0" entsprechendes Masse- bzw. Erdpotential - das Dauersignal DS - zugeführt, da der Türkontakt TK bei der Schaltungsanordnung gemäß Fig. 1 oder gemäß Fig. 2 noch geöffnet ist, so wird dem Rücksetzeingang D des bistabilen Kippgliedes KS in dem bistabilen Steuerglied SG1 in diesem Fall ein einem Binärsignal "1" entsprechendes Potential zugeführt, und dem D-Eingang des betreffenden bistabilen Kippgliedes KS wird ein einem Binärsignal "0" entsprechendes Potential zugeführt. Durch dieses Binärsignal wird das bistabile Kippglied KS in seinen Rücksetzzustand eingestellt, falls es sich nicht bereits in diesem Rücksetzzustand befindet. In diesem Fall gibt das bistabile Kippglied KS von seinem Ausgang Q ein einem Binärsignal "1" entsprechendes Ausgangssignal und von seinem Ausgang *Q̅* ein einem Binärsignal "0" entsprechendes Ausgangssignal ab.

Wird jedoch bei dem zuvor angenommenen Rücksetzzustand des bistabilen Kippgliedes KS allein dem Eingangsanschluss E21 des bistabilen Steuergliedes SG1 ein einem Binärsignal "0" entsprechendes Masse- bzw. Erdpotential in Form des Dauersignals DS zugeführt, so liegt am Eingangs- bzw. Datenanschluss D des bistabilen Kippgliedes KS sodann ein einem Binärsignal "1" entsprechendes Signal an, und am Rücksetzeingang R dieses Kippgliedes KS liegt ein einem Binärsignal "0" entsprechendes Potential an. Dies allein hat jedoch noch keinerlei Auswirkung auf den Einstellzustand des bistabilen Kippgliedes KS. Erst wenn jetzt, also während der Abgabe des erwähnten Dauersignals DS zusätzlich ein Impulssignal IS ("1") am Eingangsanschluss E11 des bistabilen Steuergliedes SG1 und damit am Takteingang T des bistabilen Kippgliedes KS auftritt, wird dessen Einstellzustand in den Setzzustand geändert, in welchen nunmehr vom Ausgangsanschluss *Q̅* dieses bistabilen Kippgliedes KS ein Ausgangssignal entsprechend einem Binärsignal "1" abgegeben wird, welches zum Schließen des zugehörigen Schaltgliedes SW1 führt. Ein anschließendes erneutes ein- oder mehrmaliges Auftreten des erwähnten Impulssignals IS am Eingangsanschluss E11 ändert den erreichten Einstellzustand des bistabilen Kippgliedes KS nicht. Erst wenn das dem Eingangsanschluss E21 zugeführte Dauersignal DS ("0") wieder verschwindet, wird dem Rücksetzeingang R des bistabilen Kippgliedes KS ein einem Binärsignal "1" entsprechendes Signal zugeführt, aufgrund dessen dieses bistabile Kippglied KS auch ohne ein Impulssignal IS und damit auch ohne ein Taktsignal an seinem Takteingang C wieder in seinen Rücksetzzustand gelangt, in welchem von seinem Ausgangsanschluss *Q* ein einem Binärsignal "1" entsprechendes Potential und von seinem Ausgangsanschluss *Q̅* ein einem Binärsignal "0" entsprechendes Potential abgegeben wird, aufgrund dessen das zugehörige Schaltglied SW1 wieder geöffnet wird.

Wird anschließend lediglich dem Eingangsanschluss E21 wieder das Dauersignal ("0") zugeführt, so hat dies keinerlei Auswirkung auf den Einstellzustand des bistabilen Kippgliedes KS - es verbleibt in seinem Rücksetzzustand. Damit erfüllt auch diese Schaltungsanordnung die Forderungen, die an eine geschützte Schaltung (PEC) gestellt sind, wie dies eingangs erwähnt worden ist.

Die in Fig. 4 dargestellte Realisierungsform des bistabilen Steuergliedes SG1 zeigt eine Nachbildungsschaltung eines Thyristors, bestehend aus zwei miteinander gekoppelten Bipolar-Transistoren, nämlich einem Transistor T1 des npn-Leitfähigkeitstyps und einem Transistor T2 des pnp-Leitfähigkeitstyps. Dabei ist der Transistor T1 mit seiner Basis mit dem Kollektor des Transistors T2 verbunden, der wiederum mit seiner Basis mit dem Kollektor des Transistors T1 verbunden ist. Der gemeinsame Verbindungspunkt des Kollektors des Transistors T1 und der Basis des Transistors T2 ist über ein Reihen-RC-Glied, bestehend aus einem ohmschen Widerstand R1 und einem Kondensator C2 mit dem Eingangsanschluss E11 des bistabilen Steuergliedes SG1 verbunden. Außerdem ist der gerade genannte gemeinsame Verbindungspunkt zwischen dem Kollektor des Transistors T1 und der Basis des Transistors T2 über einen ohmschen Widerstand R2 an einem eine positive Versorgungsspannung von zum Beispiel +5V führenden Schaltungspunkt +U_{B} angeschlossen, mit dem auch der Emitter des Transistors T2 verbunden ist. Der gemeinsame Verbindungspunkt zwischen der Basis des Transistors T1 und dem Kollektor des Transistors T2 ist zum einen über einen ohmschen Widerstand R3 mit dem Eingangsanschluss E21 und zum anderen gegebenenfalls direkt mit dem Ausgangsanschluss AS1 des bistabilen Steuergliedes SG1 verbunden. Mit dem Eingangsanschluss E21 des bistabilen Steuergliedes SG1 ist schließlich auch der Emitter des Transistors T1 verbunden. Im Folgenden wird die Arbeitsweise der in Fig. 4 dargestellten Schaltungsanordnung des bistabilen Steuergliedes SG1 kurz erläutert. Werden dem Eingangsanschluss E11 des in Fig. 4 dargestellten bistabilen Steuergliedes SG1 ein oder mehrere Impulssignale IS zugeführt, wie sie anhand der Fig. 1 und 2 erwähnt worden sind, so hat dies solange keine Auswirkung, wie dem Eingangsanschluss E21 des bistabilen Steuergliedes SG1 kein Dauersignal DS in Form eines Masse- bzw. Erdpotentials zugeführt wird. Die dargestellte Thyristor-Nachbildungsschaltung mit den beiden Transistoren T1 und T2 verbleibt in ihrem Ausgangszustand, in welchem beide Transistoren T1, T2 nichtleitend sind.

Wird andererseits ohne das zuvor erwähnte Impulssignal IS lediglich ein Dauersignal DS, wie es anhand der Fig. 1 und 2 erwähnt worden ist, dem Eingangsanschluss E21 des bistabilen Steuergliedes SG1 zugeführt, so bewirkt auch dieses Dauersignal DS keine Änderung im Leitzustand der beiden Transistoren T1 und T2. Wird jedoch dieses Dauersignal DS, also im vorliegenden Fall Masse- bzw. Erdpotential dem Eingangsanschluss E21 zugeführt und wird gleichzeitig dem Eingangsanschluss E11 des bistabilen Steuergliedes SG1 ein Impulssignal IS gemäß Fig. 1 und 2 zugeführt, so führt die differenzierende Wirkung durch das ein Differenzierglied bildende RC-Glied R1, C1 dazu, dass die aus den Transistoren T1 und T2 bestehende Thyristor-Nachbildungsschaltung gewissermaßen gezündet wird. Dies bedeutet, dass beide Transistoren T1 und T2 nunmehr in den leitenden Zustand gelangen, in welchem vom gemeinsamen Verbindungspunkt des Kollektors des Transistors T2 und der Basis des Transistors T1 und damit vom Ausgangsanschluss AS1 des bistabilen Steuergliedes SG1 ein dem Potential ("1") am Schaltungspunkt +U_{B} entsprechendes Potential ("1") abgegeben wird, aufgrund dessen das mit dem Ausgangsanschluss AS1 verbundene Schaltglied SW1 ein- bzw. durchgeschaltet wird.

Dieser zuletzt erwähnte Zustand der Thyristor-Nachbildungsschaltung und damit des Schaltgliedes SW1 bleibt unabhängig vom Auftreten oder Nichtauftreten von weiteren Impulssignalen IS am Eingangsanschluss E11 des bistabilen Steuergliedes SG1 solange erhalten, bis am Eingangsanschluss E21 des bistabilen Steuergliedes SG1 das Dauersignal (Masse- bzw. Erdpotential) wieder verschwindet. In diesem Fall gelangen die beiden Transistoren T1 und T2 gemäß Fig. 4 wieder in ihren nichtleitenden Zustand.

In diesem zuletzt erwähnten Zustand - in welchem sich beide Transistoren T1 und T2 jeweils im nichtleitenden Zustand befinden -führt die alleinige Zuführung des Dauersignals DS, also von Masse- bzw. Erdpotential zum Eingangsanschluss E21 nicht dazu, dass die beiden Transistoren T1 und T2 wieder in den leitenden Zustand gelangen. Damit erfüllt auch diese Schaltungsanordnung die Forderungen, die an eine geschützte elektronische Schaltung (PEC) gestellt sind, wie dies eingangs erwähnt worden ist.

Abschließend sei noch angemerkt, dass die bistabilen Steuerglieder SG1, SG2 auch in anderer Weise, als zuvor anhand der Fig. 3 und 4 erläutert, realisiert sein können. So können die betreffenden bistabilen Steuerglieder SG1, SG2 beispielsweise durch andere bistabile Kippglieder oder durch normale Thyristoren oder Triacs realisiert sein, sofern diese bistabilen Steuerglieder in der oben erläuterten Weise auf die Zuführung eines Dauersignals und eines Impulssignals hin in der beschriebenen Weise arbeiten.

### Bezugszeichenliste

- AS1, AS2: Ausgangsanschluss
- C: Takteingang
- C1: Kondensator
- D: Eingangs- bzw. Datenanschluss
- DS: Dauersignal
- E11, E12, E21, E22: Eingangsanschluss
- EA1, EA2: Eingangsanschluss
- EA3: Ausgangsanschluss
- IS: Impulssignal
- K1, K2, K3: Relaiskontakt
- KS: bistabiles Kippglied
- N: Schaltungspunkt
- NG: Negator bzw. Nicht-Glied
- *Q*, *Q̅*: Ausgangsanschluss
- R: Rücksetzeingang
- R1, R2, R3: Ohmscher Widerstand
- RE: Relaistreiber
- RK1, RK2: Eingangsanschluss
- RW1, RW2, RW3: Relaiswicklung
- SG1, SG2: bistabiles Steuerglied
- ST: Steuereinrichtung
- SW1, SW2: Schalteinrichtung
- T: Takteingang
- T1, T2: Transistor, Bipolar-Transistor
- TA: Impulssignal- Abgabeeinrichtung
- TK: Dauersignal-Abgabeeinrichtung, Türkontakt
- U: Schaltungspunkt
- +U_{B}: Schaltungspunkt
- V1, V2, V3: elektrischer Aktor und/oder Sensor und/oder Verbraucher

## Patentansprüche

1. Verfahren zur sicheren Ansteuerung von Aktoren und/oder Sensoren und/oder Verbraucher eines elektrischen Hausgeräts in Form einer elektrisch arbeitenden Waschmaschine oder eines elektrisch arbeitenden Wäschetrockners, wobei das Hausgerät eine Relaisschaltung (RW1, RW2, RW3, K1, K2, K3) umfasst, die mit einer Steuereinrichtung (ST) und mit den Aktoren und/oder Sensoren und/oder Verbrauchern (V1, V2, V3) verbunden ist und die von der Steuereinrichtung (ST) ansteuerbar ist, **gekennzeichnet durch** wenigstens zwei entsprechend einer UND-Verknüpfung betriebenen Schaltgliedern zum Wirksamschalten der genannten Aktoren und/oder Sensoren und/oder Verbraucher **durch** auf die Schaltglieder einwirkende Steuersignale, wobei die UND-Verknüpfung **durch** eine Reihenschaltung der Schaltglieder dargestellt ist, und eine Dauerssignal Abgabeeinrichtung **durch** einen Türschalterkontakt (TK) des Hausgeräts gebildet wird,
**dadurch gekennzeichnet, dass**
und dass als Steuersignale ein Dauersignal (DS) und ein Impulssignal (IS) an eine der Anzahl der Schaltglieder (SW1, SW2) entsprechende Anzahl von bistabilen Steuergliedern (SG1, SG2) abgegeben werden, die lediglich **durch** die Abgabe des genannten Dauersignals (DS) und **durch** die während der Abgabe des betreffenden Dauersignals erfolgende Abgabe des genannten Impulssignals (IS) in einen eingeschalteten Zustand gebracht werden, in welchem die Schaltglieder (SW1, SW2) wirksam geschaltet werden, und die allein **durch** Abschalten des genannten Dauersignals (DS) in den ausgeschalteten Zustand gebracht werden, in welchem die Schaltglieder (SW1, SW2) abgeschaltet, und in diesem ausgeschalteten Zustand auch bei erneuter Abgabe des betreffenden Dauersignals (DS) gehalten werden
dass ein Ende der in Reihe geschalteten Schaltglieder (SW1, SW2) im Speigestromkreis der den Aktoren und/oder Sensoren und/oder Verbraucher (V₁, V₂, V₃) zugehörigen Relais mit jeweils einem Ende der Relaiswicklungen (RW1, RW2, RW3) der Relais oder im Speigestromkreis der mit Kontakten (K1, K2, K3) der den Aktoren und/oder Sensoren und/oder Verbraucher zugehörigen Relais in Reihegeschalteten Aktoren und/oder Sensoren und/oder Verbraucher (V₁, V₂, V₃) mit jeweils einem Ende der Kontakte (K₁, K₂, K₃) verbunden wird,
und dass der Türschalterkontakt (TK) im Stromkreis der Relais mit dem jeweils einen Ende der Relaiswicklungen (RW1, RW2, RW3) verbunchen wird und mit seinem anderen Schaltkontaktanschluss auf Masse gelegt wird.

2. Verfahren nach Anspruch 1, **dadurch gekennzeichnet, dass** die Abgabe des Impulssignals (IS) überwacht wird und dass lediglich bei dessen Abgabe mit einer unterhalb einer festgelegten Dauer liegenden Dauer und bei Vorhandensein des genannten Dauersignals (DS) die genannten Aktoren und/oder Sensoren und/oder Verbraucher (V1, V2, V3) wirksam geschaltet werden.

3. Verfahren nach Anspruch 1 oder 2, **dadurch gekennzeichnet, dass** das Dauersignal auf seine ordnungsgemäße Abgabe bzw. auf sein Vorhandensein überwacht wird.

4. Verfahren nach einem der Ansprüche 1 bis 3, **dadurch gekennzeichnet, dass** von den beiden bistabilen Steuergliedern (SG1, SG2) abgegebene Ausgangssignale (AS1, AS2) auf ihre ordnungsgemäße Abgabe überwacht werden.

5. Verfahren nach den Ansprüchen 2, 3 und 4, **dadurch gekennzeichnet,**
**dass** die Abgabe des Impulssignals (IS), des Dauersignals (DS) und der Ausgangssignale (AS1, AS2) der bistabilen Steuerglieder (SG1, SG2) in einer Steuereinrichtung (ST) überwacht wird, durch die lediglich bei ordnungsgemäßem Auftreten des Impulssignals (IS), des Dauersignals (DS) und der Ausgangssignale (AS1, AS2) der bistabilen Steuerglieder (SG1, SG2) die Aktoren, und/oder Sensoren und/oder Verbraucher durch die Schaltglieder (SW1, SW2) wirksam gesteuert werden.

6. Schaltungsanordnung eines elektrischen Hausgeräts in Form einer elektrisch arbeitenden Waschmaschine oder eines elektrisch arbeitenden Wäschetrockners zur Durchführung des Verfahrens nach einer der Ansprüche 1 bis 5, für eine sichere Ansteuerung von Aktoren und/oder Sensoren und/oder Verbraucher des Hausgeräts, mit einer Relaisschaltung (RW1, RW2, RW3, K1, K2, K3), die mit einer Steuereinrichtung (ST) und mit den Aktoren und/oder Sensoren und/oder Verbrauchern (V1, V2, V3) verbunden ist und die von der Steuereinrichtung (ST) ansteuerbar ist, **gekennzeichnet durch** wenigstens zwei entsprechend einer UND-Verknüpfung betriebenen Schaltgliedern zum Wirksamschalten der genannten Aktoren und/oder
Sensoren und/oder Verbraucher **durch** auf die Schaltglieder einwirkende Steuersignale, wobei die UND-Verknüpfung **durch** eine Reihenschaltung der Schaltglieder dargestellt ist, und
**dadurch gekennzeichnet, dass** eine der Anzahl der Schaltglieder (SW1, SW2) entsprechende Anzahl von bistabilen Steuergliedern (SG1, SG2), die jeweils zwei Steuereingänge (E11, E12, E21, E22) und jeweils einen Ausgang (AS1, AS2) aufweisen, umfasst ist, dass für eine Steuersignalabgabe eine Impulssignal-Abgabeeinrichtung (TA) und eine Dauersignal-Abgabeeinrichtung (TK) vorgesehen sind, wobei die Impulssignal-Abgabeeinrichtung (TA) mit jeweils einem der zwei Steuereingänge (E11, E12), die Dauersignal-Abgabeeinrichtung (TK) mit jeweils dem anderen der zwei Steuereingänge (E21, E22) und jeweils der Ausgang (AS1, AS2) der Steuerglieder (SG1, SG2) mit jeweils einem Betätigungseingang des entsprechenden Schaltglieds (SW1, SW2) elektrisch verbunden sind, wobei die Dauersignal-Abgabeeinrichtung (TK) ein Türkontakt der Waschmaschine oder des Wäschetrockners darstellt, dass die bistabilen Steuerglieder (SG1, SG2) **durch** die Abgabe eines Dauersignals (DS) der Dauersignal-Abgabeeinrichtung (TK) und des betreffenden Dauersignals erfolgende Abgabe eines Impulssignals (IS) der Impulssignal-Abgabeeinrichtung (TA) in einen eingeschalteten Zustand (Setzzustand) steuerbar sind, in welchem die Schaltglieder (SW1, SW2) wirksam schaltbar sind, und die allein **durch** Abschalten des genannten Dauersignals (DS) in einen ausgeschalteten Zustand (Rücksetzzustand) steuerbar, in welchem die Schaltglieder (SW1, SW2) wirksam abgeschaltet sind, und in diesem ausgeschalteten Zustand auch bei erneuter Abgabe des betreffenden Dauersignals (DS) haltbar sind,
dass ein Ende der in Reihe geschalteten Schaltglieder (SW1, SW2) im Speisestromkreis der den Aktoren und/oder Sensoren und/oder Verbraucher (V₁,V₂, V₃) zugehörigen Relais mit jeweils einem Ende der Relaiswicklungen (RW1, RW2 RW3) der Relais oder im Speistromkreis der mit Kontakten (K₁, K₂, K₃) der den Aktoren und/oder Sensoren und/oder
Verbraucher (V₁, V₂, V₃) zugehörigen Relais in Reihe geschalteten Aktoren und/oder Sensoren und/oder Verbraucher (V1, V2, V3) mit jeweils einem Ende der Kontakte (K1, K2, K3) verbunden ist,
und dass der Türschalterkontakt (TK) im Stromkreis des Relais mit dem jeweils einen Ende des Relaiswicklungen (RW1, RW2, RW3) verbunden ist und mit seinem anderen Schaltkontaktanschluss auf Masse liegt.

7. Schaltungsanordnung nach Anspruch 6, **dadurch gekennzeichnet, dass** eine Impulssignal-Überwachungseinrichtung (ST) vorgesehen ist, durch die eine solche Überwachung des Impulssignals (IS) vornehmbar ist, dass lediglich bei Abgabe eines Impulssignals (IS) mit einer unterhalb einer festgelegten Dauer liegenden Dauer und bei Vorhandensein des genannten Dauersignals (DS) die Schaltglieder (SW1, SW2) wirksam schaltbar sind.

8. Schaltungsanordnung nach Anspruch 6 oder 7, **dadurch gekennzeichnet, dass** eine Dauersignal-Überwachungseinrichtung (ST) vorgesehen ist, die das von einer Dauersignal-Abgabeeinrichtung, (TK) abgegebene Dauersignal (DS) auf seine ordnungsgemäße Abgabe überwacht.

9. Schaltungsanordnung nach einem der Ansprüche 6 bis 8, **dadurch gekennzeichnet, dass** die bistabilen Steuerglieder (SG1, SG2) ausgangsseitig mit einer- Überwachungseinrichtung (ST) verbunden sind, welche die Abgabe der von den betreffenden bistabilen Steuergliedern (SG1, SG2) jeweils abzugebenden Ausgangssignale (AS1, AS2) überwacht.

10. Schaltungsanordnung nach den Ansprüchen 7, 8 und 9, **dadurch gekennzeichnet, dass** die Überwachungseinrichtungen in einer gemeinsamen Steuereinrichtung (ST) enthalten sind.

11. Schaltungsanordnung nach Anspruch 10, **dadurch gekennzeichnet, dass** die Steuereinrichtung (ST) einen Mikrocontroller enthält.

12. Schaltungsanordnung nach einem der Ansprüche 6 bis 11, **dadurch gekennzeichnet, dass** die Impulssignal-Abgabeeinrichtung (TA) durch einen Taster (TA) gebildet ist und dass die Dauersignal-Abgabeeinrichtung (TK) durch einen von dem Taster (TA) unabhängig betätigbaren Türschalterkontakt (TK) des elektrischen Hausgerätes gebildet ist.

13. Schaltungsanordnung nach einem der Ansprüche 6 bis 12, **dadurch gekennzeichnet, dass** jedem Aktor und/oder Sensor und/oder Verbraucher (V1, V2, V3) ein gesondertes Relais (RW1, RW2, RW3) zugehörig ist.

14. Schaltungsanordnung nach einem der Ansprüche 6 bis 13, **dadurch gekennzeichnet, dass** die bistabilen Steuerglieder (SG1, SG2) jeweils durch ein bistabiles Schaltungsglied (KS; T1, T2) gebildet sind.

15. Schaltungsanordnung nach Anspruch 14, **dadurch gekennzeichnet, dass** die bistabilen Steuerglieder (SG1, SG2) jeweils aus Halbleiterelementen (KS; T1, T2) aufgebaut sind.

16. Schaltungsanordnung nach einem der Ansprüche 6 bis 15, **dadurch gekennzeichnet, dass** die Schaltglieder (SW1, SW2) durch Halbleiterelemente gebildet sind.

## Claims

1. Method for reliable activation of actuators and/or sensors and/or consumers of an electrical domestic appliance in the form of an electrically operating washing machine or an electrically operating laundry dryer, wherein the domestic appliance comprises a relay circuit (RW1, RW2, RW3, K1, K2, K3), which is connected with a control device (ST) and with the actuators and/or sensors and/or consumers (V1, V2, V3) and which is activatable by the control device (ST), **characterised by** at least two switching elements, which are operated in correspondence with an AND linking, for switching the said actuators and/or sensors and/or consumers to be effective by control signals acting on the switching elements, wherein the AND linking is represented by a series connection of the switching elements, and **characterised in that** a continuous signal output device is formed by a door switch contact (TK) of the domestic appliance and that as control signals a continuous signal (DS) and a pulsed signal (IS) are issued to a number, which corresponds with the number of switching elements (SW1, SW2), of bistable control elements (SG1, SG2), which are brought merely by the output of the said continuous signal (DS) and by the output, which takes place during the output of the relevant continuous signal, of the said pulsed signal (IS) into a switched-on state in which the switching elements (SW1, SW2) are switched to be effective, and which are brought solely by switching-off of the said continuous signal (DS) into the switched-off state in which the switching elements (SW1, SW2) are switched off, and are kept in this switched-off state even in the case of fresh output of the relevant continuous signal (DS), that one end of the serially connected switching elements (SW1, SW2) is connected in the current supply circuit of the relays, which belong to the actuators and/or sensors and/or consumers (V1, V2, V3), with one end of each of the relay windings (RW1, RW2, RW3) of the relays or is connected in the current supply circuit of the actuators and/or sensors and/or consumers (V1, V2, V3), which are connected in series with contacts (K1, K2, K3) of the relays belonging to the actuators and/or sensors and/or consumers, with one end of each of the contacts (K1, K2, K3), and that the door switch contact (TK) is connected in the current circuit of the relay with the one end of each of the relay windings (RW1, RW2, RW3) and applied by its other switch contact terminal to ground.

2. Method according to claim 1, **characterised in that** the output of the pulsed signal (IS) is monitored and that the said actuators and/or sensors and/or consumers (V1, V2, V3) are switched to be effective merely on output of the pulsed signal with a duration lying below a fixed duration and in the case of presence of the said continuous signal (DS).

3. Method according to claim 1 or 2, **characterised in that** the continuous signal is monitored for correct output thereof or the presence thereof.

4. Method according to any one of claims 1 to 3, **characterised in that** output signals (AS1, AS2), which are issued by the two bistable control elements (SG1, SG2), are monitored for correct output thereof.

5. Method according to claims 2, 3 and 4, **characterised in that** the output of the pulsed signal (IS), the continuous signal (DS) and the output signal (AS1, AS2) of the bistable control elements (SG1, SG2) is monitored in a control device (ST), by which the actuators and/or sensors and/or consumers are controlled via the switching elements (SW1, SW2) to be effective merely in the case of correct occurrence of the pulsed signal (IS) the continuous signal (DS) and the output signals (AS1, AS2) of the bistable control elements (SG1, SG2).

6. Circuit arrangement of an electrical domestic appliance in the form of an electrically operating washing machine or an electrically operating laundry dryer, for performance of the method according to any one of claims 1 to 5, for reliable activation of actuators and/or sensors and/or consumers of the domestic appliance, comprising a relay circuit (RW1, RW2, RW3, K1, K2, K3), which is connected with a control device (ST) and with the actuators and/or sensors and/or consumers (V1, V2, V3) and which is activatable by the control device (ST), **characterised by** at least two switching elements, which are operated in correspondence with an AND linking, for switching the said actuators and/or sensors and/or consumers to be effective by control signals acting on the switching elements, wherein the AND linking is represented by a series connection of the switching elements, and **characterised in that** a number, which corresponds with the number of switching elements (SW1, SW2), of bistable control elements (SG1, SG2), which each have two control inputs (E11, E12, E21, E22) and an output (AS1, AS2), is included, that a pulsed signal output device (TA) and a continuous signal output device (TK) are provided for a control signal output, wherein the pulsed signal output device (TA) is electrically connected with a respective one of the two control inputs (E11, E12), the continuous signal output device (TK) is electrically connected with the respective other one of the two control inputs (E21, E22) and the output (AS1, AS2) of each of the control elements (SG1, SG2) is electrically connected with a respective actuating input of the corresponding switching element (SW1, SW2), wherein the continuous signal output device (TK) represents a door component of the washing machine or the laundry dryer, that the bistable control elements (SG1, SG2) are controllable by the output of a continuous signal (DS) of the continuous signal output device (TK) and the output, which ensues from the relevant continuous signal, of a pulsed signal (IS) of the pulsed signal output device (TA) into a switched-on state (set state) in which the switching elements (SW1, SW2) are switchable to be effective and which are controllable solely by switching-off of the said continuous signal (DS) into a switched-off state (reset state) in which the switching elements (SW1, SW2) are switched off in terms of effectiveness, and can be kept in this switched-off state even in the case of fresh output of the relevant continuous signal (DS), that one end of the serially connected switching elements (SW1, SW2) is connected in the current supply circuit of the relays, which belong to the actuators and/or sensors and/or consumers (V1, V2, V3), with one end of each of the relay windings (RW1, RW2, RW3) of the relays or is connected in the current supply circuit of the actuators and/or sensors and/or consumers (V1, V2, V3), which are connected in series with contacts (K1, K2, K3) of the relays belonging to the actuators and/or sensors and/or consumers, with one end of each of the contacts (K1, K2, K3), and that the door switch contact (TK) is connected in the current circuit of the relay with the one end of each of the relay windings (RW1, RW2, RW3) and applied by its other switch contact terminal to ground.

7. Circuit arrangement according to claim 6, **characterised in that** a pulsed signal monitoring device (ST) is provided, by which monitoring of the pulsed signal (IS) can be undertaken in such a manner that the switching elements (SW1, SW2) are switchable to be effective merely in the case of output of a pulsed signal (IS) with a duration lying below a fixed duration and in the case of presence of the said continuous signal (DS).

8. Circuit arrangement according to claim 6 or 7, **characterised in that** a continuous signal monitoring device (ST) is provided which monitors the continuous signal (DS), which is issued by a continuous signal output device (TK), for correct output thereof.

9. Circuit arrangement according to any one of claims 6 to 8, **characterised in that** the bistable control elements (SG1, SG2) are connected at the output side with a monitoring device (ST) which monitors the output of the output signals to be respectively issued by the relevant bistable control elements (SG1, SG2).

10. Circuit arrangement according to claims 7, 8 and 9, **characterised in that** the monitoring devices are included in a common control device (ST).

11. Circuit arrangement according to claim 10, **characterised in that** the monitoring device (S10) includes a microcontroller.

12. Circuit arrangement according to any one of claims 6 to 11, **characterised in that** the pulsed signal output device (TA) is formed by a button (TA) and that the continuous signal output device (TK) is formed by a door switch contact (TK), which is actuable independently of the button (TA), of the electrical domestic appliance.

13. Circuit arrangement according to any one of claims 6 to 12, **characterised in that** a separate relay (RW1, RW2, RW3) is associated with each actuator and/or sensor and/or consumer (V1, V2, V3).

14. Circuit arrangement according to any one of claims 6 to 13, **characterised in that** the bistable control elements (SG1, SG2) are each formed by a respective bistable switching element (KS; T1, T2).

15. Circuit arrangement according to claim 14, **characterised in that** the bistable control elements (SG1, SG2) are each constructed from semiconductor elements (KS; T1, T2).

16. Circuit arrangement according to any one of claims 6 to 15, **characterised in that** the switching elements (SW1, SW2) are formed by semiconductor elements.

## Revendications

1. Procédé pour la commande assurée d'actionneurs et/ou de capteurs et/ou de récepteurs d'un appareil électroménager sous forme d'un lave-linge fonctionnant électriquement ou d'un sèche-linge fonctionnant électriquement, dans lequel l'appareil ménager comprend un circuit de relais (RW1, RW2, RW3, K1, K2, K3), qui est relié à un dispositif de commande (ST) et aux actionneurs et/ou capteurs et/ou récepteurs (V1, V2, V3) et qui peut être commandé par le dispositif de commande (ST), **caractérisé par** au moins deux éléments de commutation fonctionnant selon une fonction logique ET pour une commutation d'activation desdits actionneurs et/ou capteurs et/ou récepteurs par des signaux de commande agissant sur les éléments de commutation, dans lequel la fonction logique ET est représentée par un montage en série des éléments de commutation, et
**caractérisé en ce que**,
un dispositif d'émission de signal continu est formé par un contact d'interrupteur de porte (TK) de l'appareil ménager, et qu'à titre de signaux de commande, un signal continu (DS) et un signal à impulsion (IS) sont émis vers un nombre d'éléments de commande bistable (SG1, SG2) correspondant au nombre d'éléments de commutation (SW1, SW2), qui sont amenés dans un état de marche uniquement par l'émission dudit signal continu (DS) et par l'émission dudit signal à impulsion (IS) ayant lieu pendant l'émission du signal continu en question, dans lequel les éléments de commutation (SW1, SW2) sont commutés en activation, et qui sont amenés dans l'état désactivé uniquement par la coupure dudit signal continu (DS), état désactivé dans lequel sont désactivés les éléments de commutation (SW1, SW2) et également maintenus lors d'une nouvelle émission du signal continu (DS) en question, **en ce qu'**une extrémité des éléments de commutation (SW1, SW2) branchés en série dans le circuit de courant d'alimentation des relais associés aux actionneurs et/ou capteurs et/ou récepteurs (V1, V2, V3) est reliée respectivement à une extrémité des bobines de relais (RW1, RW2, RW3) des relais ou dans le circuit de courant d'alimentation des actionneurs et/ou capteurs et/ou récepteurs (V1, V2, V3) branchés en série avec des contacts (K1, K2, K3) des relais associés aux actionneurs et/ou capteurs et/ou récepteurs, est reliée respectivement à une extrémité des contacts (K1, K2, K3),
et que le contact d'interrupteur de porte (TK) dans le circuit des relais est relié respectivement à ladite une extrémité des bobines de relais (RW1, RW2, RW3) et est mis à la masse avec son autre connexion.

2. Procédé selon la revendication 1, **caractérisé en ce que** l'émission du signal à impulsion (IS) est contrôlée et que seulement lorsqu'il est émis avec une durée inférieure à la durée fixée, et lorsque ledit signal continu (DS) est présent, lesdits actionneurs et/ou capteurs et/ou récepteurs (V1, V2, V3) sont commutés en activation.

3. Procédé selon la revendication 1 ou 2, **caractérisé en ce que** le signal continu est contrôlé quant à son émission en bonne et due forme ou sa présence.

4. Procédé selon l'une quelconque des revendications 1 à 3, **caractérisé en ce que** des signaux de sortie (AS1, AS2) émis par les deux éléments de commande bistables (SG1, SG2) sont contrôlés quant à leur émission en bonne et due forme.

5. Procédé selon les revendications 2, 3 et 4, **caractérisé en ce que** l'émission du signal à impulsion (IS), du signal continu (DS) et des signaux de sortie (AS1, AS2) des éléments de commande bistable (SG1, SG2) est contrôlée dans un dispositif de commande (ST), par lequel, uniquement en cas de bonne et due forme du signal à impulsion (IS), du signal continu (DS) et des signaux de sortie (AS1, AS2) des éléments de commande bistables (SG1, SG2), les actionneurs et/ou capteurs et/ou récepteurs sont commandés en activation par les éléments de commutation (SW1, SW2).

6. Disposition de circuit d'un appareil électroménager sous forme d'un lave-linge fonctionnant électriquement ou d'un sèche-linge fonctionnant électriquement pour réaliser le procédé selon l'une quelconque des revendications 1 à 5, pour une commande assurée des actionneurs et/ou capteurs et/ou récepteurs de l'appareil ménager avec un circuit de relais (RW1, RW2, RW3, K1, K2, K3), qui est relié à un dispositif de commande (ST) et aux actionneurs et/ou capteurs et/ou récepteurs (V1, V2, V3) et qui peut être commandé par le dispositif de commande (ST), **caractérisé en ce qu'**au moins deux éléments de commutation fonctionnant selon une fonction logique ET pour commuter en activation lesdits actionneurs et/ou capteurs et/ou récepteurs par des signaux de commande agissant sur les éléments de commutation, la fonction logique ET étant représentée par un circuit série des éléments de commutation, et
**caractérisée en ce qu'**elle comprend un nombre d'éléments de commande bistables (SG1, SG2) qui présentent chacun deux entrées de commande (E11, E12, E21, E22) et une sortie (AS1, AS2), nombre correspondant au nombre des éléments de commutation (SW1, SW2), **en ce qu'**un dispositif d'émission de signaux à impulsion (TA) et un dispositif d'émission de signaux continus (TK) sont prévus pour émettre des signaux de commande, le dispositif d'émission de signaux à impulsion (TA) étant relié électriquement respectivement à l'une des deux entrées de commande (E11, E12), le dispositif d'émission de signaux continus (TK) étant relié électriquement respectivement à l'autre des deux entrées de commande (E21, E22) et respectivement la sortie (AS1, AS2) des éléments de commande (SG1, SG2) étant reliée respectivement à une entrée d'actionnement de l'élément de commutation correspondant (SW1, SW2), le dispositif d'émission de signaux continus (TK) représentant un contact de porte du lave-linge ou du sèche-linge, **en ce que** les éléments de commande bistables (SG1, SG2) peuvent être commandés dans un état activé (état mis à un), par l'émission d'un signal continu (DS) du dispositif d'émission de signaux continus (TK) et l'émission d'un signal à impulsion (IS) du dispositif d'émission de signaux à impulsion (TA) ayant lieu du signal continu en question, dans lequel les éléments de commutation (SW1, SW2) peuvent être commutés en activation, et qui peuvent être commandés uniquement par la coupure dudit signal continu (DS) dans un état de mise hors circuit (état mis à zéro), dans lequel les éléments de commutation (SW1, SW2) sont désactivés, et peuvent être maintenus dans cet état de mise hors circuit également lors d'une nouvelle émission du signal continu (DS) en question, **en ce qu'**une extrémité des éléments de commutation (SW1, SW2) branchés en série dans le circuit de courant d'alimentation des relais associés aux actionneurs et/ou capteurs et/ou récepteurs (V1, V2, V3) est reliée respectivement à une extrémité des bobines de relais (RW1, RW2, RW3) des relais, ou dans le circuit de courant d'alimentation des actionneurs et/ou capteurs et/ou récepteurs (V1, V2, V3) branchés en série avec des contacts (K1, K2, K3) des relais associés aux actionneurs et/ou capteurs et/ou récepteurs, est reliée respectivement à une extrémité des contacts (K1, K2, K3),
et que le contact d'interrupteur de porte (TK) dans le circuit des relais sera relié respectivement à ladite une extrémité des bobines de relais (RW1, RW2, RW3) et est mis à la masse avec son autre connexion.

7. Disposition de circuit selon la revendication 6, **caractérisée en ce qu'**un dispositif de contrôle de signaux à impulsion (ST) est prévu, à l'aide duquel on peut procéder à un contrôle du signal à impulsion (IS), tel que les éléments de commutation (SW1, SW2) peuvent être commutés en activation uniquement lors de l'émission d'un signal à impulsion (IS) ayant une durée inférieure à une durée fixée et lors de la présence dudit signal continu (DS).

8. Disposition de circuit selon la revendication 6 ou 7, **caractérisée en ce qu'**un dispositif de contrôle de signaux à impulsion (ST) est prévu, qui contrôle le signal continu (DS) émis par un dispositif d'émission de signaux continus (TK) quant à son émission en bonne et due forme.

9. Disposition de circuit selon l'une quelconque des revendications 6 à 8, **caractérisée en ce que** les éléments de commande bistables (SG1, SG2) du côté de la sortie sont reliées à un dispositif de contrôle (ST), lequel contrôle l'émission des signaux de sortie (AS1, AS2) à émettre par les éléments de commande bistables (SG1, SG2) en question.

10. Disposition de circuit selon les revendications 7, 8 et 9, **caractérisée en ce que** les dispositifs de contrôle (ST) sont contenus dans un dispositif de commande (ST) commun.

11. Disposition de circuit selon la revendication 10, **caractérisée en ce que** le dispositif de contrôle (ST) contient un microcontrôleur.

12. Disposition de circuit selon l'une quelconque des revendications 6 à 11, **caractérisée en ce que** le dispositif d'émission de signaux à impulsion (TA) est formé par un boutton-poussoir (TA) et que le dispositif d'émission de signaux continus (TK) est formé par un contact d'interrupteur de porte (TK) actionnable indépendamment du boutton-poussoir (TA) de l'appareil électroménager.

13. Disposition de circuit selon l'une quelconque des revendications 6 à 12, **caractérisée en ce qu'**un relais particulier (RW1, RW2, RW3) est associé à chaque actionneur et/ou capteur et/ou récepteur (V1, V2, V3).

14. Disposition de circuit selon l'une quelconque des revendications 6 à 13, **caractérisée en ce que** les éléments de commande bistables (SG1, SG2) sont formés respectivement par un élément de circuit bistable (KS ; T1, T2).

15. Disposition de circuit selon la revendication 14, **caractérisée en ce que** les éléments de commande bistables (SG1, SG2) sont construit respectivement d'éléments semi-conducteurs (KS ; T1, T2).

16. Disposition de circuit selon l'une quelconque des revendications 6 à 15, **caractérisée en ce que** les éléments de commutation (SW1, SW2) sont formés par des éléments semi-conducteurs.
